# EUROPEAN PATENT APPLICATION

(11) **EP 1 246 516 A1**
(43) Date of publication of application: **02.10.2002**
(21) Application number: 01302754.5
(22) Date of filing: 26.03.2001
(51) Int. Cl.: H05K 9/00

(54) **Device for electromagnetically screening of electric subassemblies, and a method for arranging screens on electric subassemblies**

(71) Applicant: LUCENT TECHNOLOGIES INC., Murray Hill, New Jersey 07974-0636 (US)
(72) Inventor: Bauernschmidt, Georg, 91327 Gössweinstein (DE); Kohls, Klaus-Joachim, 92289 Ursensollen (DE)
(74) Representative: Sarup, David Alexander

(57) **Abstract**

The invention proposes a device for screening electric circuit elements fitted on a printed circuit board (2), which comprises a housing (1) and partitions (11), and a method for arranging screens for the purpose. In this case, the housing surrounds the printed circuit board at least partially and screens the circuit elements outwards. The partitions are connected in a conducting fashion to the housing and can be connected in an electrically conducting and mechanically detachable fashion on the printed circuit board such that they screen the circuit elements from one another.

## Description

The invention relates to a device for screening electric subassemblies, and a method for arranging screens therefor in accordance with Claims 1 and 13.

Radio-frequency electromagnetic fields associated with electric currents have the property of being emitted by antennas into free space or being received. Consequently, electric or electronic radio-frequency components require the use of screens in order to ensure their functional operation. It is necessary in this case for individual components or subassemblies of circuit elements to be electrically screened both outwards and from one another.

There are already numerous screening arrangements which ensure the mode of operation of circuits arranged, for example, on a printed circuit board.

Such screens are usually formed from partitions or screening cans which are soldered onto the printed circuit boards. It is particularly important in this case to produce a low-resistance transition between the printed circuit board and the screening element.

It is disadvantageous here that the printed circuit board must be surrounded outwards in a screening fashion by a housing, and that, in addition, partitions and/or screening cans must be soldered on in the interior.

It is therefore the object of the invention to provide a device and an arrangement, respectively, for screening electric or electronic circuit elements which screens both the individual units of a circuit from one another and the entire subassembly outwards, and is easy to use.

The object is achieved with surprising ease with the aid of the features of Claims 1 and 13.

The invention is attended by the advantage that the total screening can be achieved in one assembly step and that the time-consuming additional soldering operation can be avoided. Moreover, according to the invention undesired electric short-circuiting connections which occur during soldering are avoided.

The invention provides a device for screening electric circuit elements fitted on a printed circuit board which has a housing and partitions, and a method for arranging screens therefor. The housing and the partitions are electrically conducting in this case. The housing surrounds the printed circuit board at least partially and screens the circuit elements outwards electrically. The partitions can be connected to the housing and the printed circuit board in an electrically conducting fashion. The partitions are integrated on the housing or can be fastened therein. The partitions can be connected to the printed circuit board in a mechanically detachable fashion. According to the invention, the partitions can be connected to the printed circuit board along prescribable positions such that they surround the circuit elements and screen them from one another.

In a particular embodiment of the invention, the partitions can be connected in an electrically conducting and mechanically detachable fashion to the printed circuit board with the aid of contact elements in the form of contact springs. According to the invention, the contact elements can be fastened on the partitions and/or on the printed circuit board. This produces the advantage that the contact elements can also be fitted as early as when inserting components in the printed circuit board by machine.

In one embodiment of the invention, the housing is designed in a half shell which can be mounted on the printed circuit board and surrounds the subassembly on the printed circuit board on three sides in a screening fashion.

A housing with a circumferential frame, a cover and a bottom plate are provided in another design of the invention. The frame is preferably connected in one piece to the cover and the bottom plate in a conducting and/or mechanically detachable fashion. In a preferred embodiment, the cover, frame and/or bottom plate are connected via spring-type contact strips. According to the invention, in this case the spring-type contact strips can be fitted on the frame and/or on the cover and/or on the bottom plate. Again, an electrically conducting foil to which the contact strips are applied in a conducting fashion can be provided between the cover and the frame. In this particular embodiment of the invention, the cover can then also be made from a dielectric material.

If the frame is multipartite, the frame parts can advantageously be interconnected in a low-resistance fashion with the aid of spring-type contact strips.

The invention is explained in more detail below with the aid of the attached drawings and with reference to an exemplary embodiment.

Figure 1 shows a section through the device according to the invention.

Figure 2 shows a top view of a printed circuit board provided with an arrangement according to the invention of contact elements.

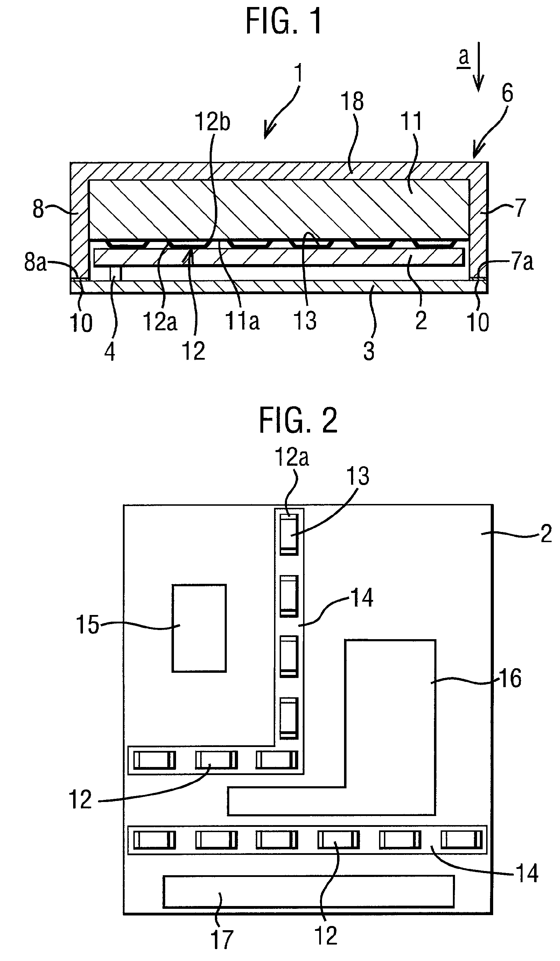

According to Figure 1, the housing symbolized by 1 surrounds the printed circuit board 2, the printed circuit board 2 being held by a bottom plate 3. The printed circuit board 2 is preferably screwed on threaded sleeves 4 which are fitted on an inner side 5 of the bottom plate 3. The housing 1 preferably contains a U-shaped press-drawn section 6, of aluminium, for example. Lateral parts 7, 8 of the press-drawn section 6 are connected to the bottom plate 3 in an electrically conducting fashion, spring-type contact strips 10 being fitted on end faces 7a, 8a of the lateral parts 7, 8 in order to produce a contact with as low a resistance as possible.

According to the invention, the housing 1 according to Figure 1 has a partition 11 between the lateral parts 7, 8. Limbs 12a of contact springs 12, which are preferably trough-shaped and fitted on the printed circuit board 2, are situated at an end face 11a of the partition 11. The partition 11 is spaced from the printed circuit board 2 according to Figure 1 by the contact springs 12. The contact springs 12 are connected to the printed circuit board 2 in an electrically conducting fashion with the aid of a bearing section 13. The bearing sections 13 are preferably soldered to corresponding conductor strips 14 (see Figure 2) on the printed circuit board 2. The contact springs 12, which are preferably formed from a copper-beryllium alloy, are tin-coated for this purpose.

According to the invention, the limbs 12a of the contact springs 12 have sharp edges 12b which incise the end face 11a of the partition 11 when the press-drawn section 6 is mounted on the bottom plate 3 in the direction indicated by the arrow a. According to the invention, a low-resistance electric contact is formed in this way between the printed circuit board 2 and the partition 11.

According to Figure 2, it is provided within the scope of the invention that individual circuit elements, fitted on the printed circuit board 2, operating in the radio-frequency region, for example, and denoted diagrammatically by 15, 16, 17, such as radio or general transmitting units, are electrically screened outwards and also from one another. According to the invention, conductor strips 14 are arranged in this case on the printed circuit board 2 such that they border on the circuit elements 15, 16 or delimit them from one another. Contact springs 12 are fitted on the conductor strips, as described above.

According to the invention, partitions 11 are present on a cover segment 18 of the press-drawn section 6 according to Figure 1 at positions which can be prescribed by the conductor strips 14. The partitions 11 are fitted on the cover segment 18 such that they are then located precisely over the conductor strips 14 in the case of the printed circuit board 2 surrounded according to the invention by the housing (1, 6).

The partitions 11 are preferably screwed with the cover segment 18 and/or at least one of the lateral parts 7, 8 or plugged into one another. In this case, contact strips 10 are provided in each case between the parts for the purpose of improving the electric contact.

When the press-drawn section 6 is mounted in accordance with the invention, the partitions 11 are located over the conductor strips 14. According to Figure 1, the contact springs 12 are pressed onto the end faces 11a of the partitions 11. An electric contact between the partitions 11 and the printed circuit board 2 is achieved thereby.

The contact springs 12 can be provided along the conductor strips 14 at different spacings from one another. In this case, the spacing both of the contact springs 12 and of two edges 12b of a contact spring 12 with respect to one another must be adapted to the operating frequency of the circuit element 15, 16, 17 to be screened. Spacings of approximately 5 to 15 mm are to be selected for many circuit elements 15, 16, 17, the aim being for the spacings to be reduced generally with rising operating frequency of the circuit elements.

The invention is not limited to the exemplary embodiment described, which can be modified in many ways. Thus, according to the invention the contact springs 12 can also be fitted otherwise than by soldering. For example, it is conceivable to provide bores on the printed circuit board into which the contact springs 12 are plugged, producing an electrically conducting connection. Likewise, it is within the scope of the present invention to press the contact springs 12 into the partitions 11, or for it to be possible to introduce them in a fashion producing an electric connection. Thus, it is conceivable to equip the contact springs 12 with pins which can be inserted into corresponding openings in the printed circuit board 2 or in the partitions 11 in order to fasten the contact springs 12.

Moreover, the contact springs 12 can also be produced from stainless steel alloys within the scope of the invention.

It goes without saying that the invention includes any desired arrangement of partitions 11 and/or screening frames. All that is required is for the arrangement of the conductor strips 14 on the printed circuit board 2 to correspond to the arrangement of the partitions 11 on the housing 1.

Finally, it goes without saying that the individual features of the invention can also be used in other combinations than those illustrated and described.

## Claims

1. Device for screening electric circuit elements (15, 16, 17) fitted on a printed circuit board (2), comprising an electrically conducting housing (1) and electrically conducting partitions (11), the housing (1) surrounding the printed circuit board (2) at least partially, and it being possible to connect the partitions (11) to the housing (1) in an electrically conducting fashion, and to the printed circuit board (2) in an electrically conducting and mechanically detachable fashion.

2. Device according to Claim 1, **characterized in that** the partitions (11) can be connected to the printed circuit board (2) along prescribable positions (14) in an electrically conducting and mechanically detachable fashion.

3. Device according to Claim 2, **characterized in that** the partitions (11) can be fastened on the housing (1) such that they can make contact with the printed circuit board (2) at the positions (14).

4. Device according to one of Claims 1 to 3, **characterized in that** the partitions (11) can be connected to the printed circuit board (2) via contact elements (12) in an electrically conducting and mechanically detachable fashion.

5. Device according to Claim 4, **characterized in that** the contact elements (12) are fastened on the partitions (11) and/or on the printed circuit board (14, 2).

6. Device according to one of Claims 1 to 5, **characterized in that** the housing (1) has a frame (7, 8), a cover (18) and a bottom plate (3).

7. Device according to Claim 6, **characterized in that** the frame (7, 8) is connected to the cover and/or the bottom plate (3) via spring-type contact strips (10) in a conducting and mechanically detachable fashion.

8. Device according to Claim 7, **characterized in that** the contact strips (10) are fitted on the frame (7, 8) and/or on the cover and/or on the bottom plate (3).

9. Device according to Claim 6, **characterized in that** an electrically conducting foil is provided between the cover and the frame (7, 8).

10. Device according to one of Claims 1 to 5, **characterized in that** the housing (6) is constructed as a half shell.

11. Device according to one of Claims 1 to 10, **characterized in that** the contact elements (12) are designed as contact springs.

12. Device according to one of Claims 1 to 11, **characterized in that** the partitions (11) are connected to the housing (1, 6) via spring-type contact strips (10) in a conducting fashion.

13. Method for arranging screens of electric circuit elements (15, 16, 17) provided on a base plate (2) in the case of which the circuit elements (15, 16, 17) are surrounded at least partially outwards by an electrically conducting screening housing (1, 6), and at least one screen (11) is arranged on the base plate (2) in an electrically conducting and mechanically detachable fashion such that the at least one screen (11) respectively screens two circuit elements (15, 16, 17) electrically from one another.

14. Method according to Claim 13, **characterized in that** the at least one screen (11) is connected to the base plate (2) via contact elements (12).

15. Method according to Claim 13 or 14, **characterized in that** the contact elements (12) are soldered on the base plate (2) such that they surround the circuit elements (15, 16, 17).

16. Method according to Claim 14 or 15, **characterized in that** the at least one screen (11) is designed as a partition and is pressed onto the contact elements (12).
